Europäisches Patentamt

European Patent Office

Office européen des brevets

(19)

(11) Veröffentlichungsnummer : **0 089 048**
**B1**

(12) EUROPÄISCHE PATENTSCHRIFT

(45) Veröffentlichungstag der Patentschrift :
29.07.87

(51) Int. Cl.⁴ : **G 01 R 19/145, H 02 H 3/24**

(21) Anmeldenummer : **83102502.8**

(22) Anmeldetag : **14.03.83**

(54) Schaltungsanordnung zur Erkennung und Speicherung von Netzfehlern.

(30) Priorität : **16.03.82 DE 3209562**

(43) Veröffentlichungstag der Anmeldung :
**21.09.83 Patentblatt 83/38**

(45) Bekanntmachung des Hinweises auf die Patenterteilung : **29.07.87 Patentblatt 87/31**

(84) Benannte Vertragsstaaten :
**AT BE CH FR GB IT LI NL**

(56) Entgegenhaltungen :
**DD-A-   149 266**
**DE-A- 2 807 321**
**GB-A- 2 023 952**
**GB-A- 2 033 681**

(73) Patentinhaber : **Siemens Aktiengesellschaft Berlin und München**
**Wittelsbacherplatz 2**
**D-8000 München 2 (DE)**

(72) Erfinder : **Schlenk, Manfred**
**Ostpreussenstrasse 14**
**D-8903 Bobingen (DE)**

## Beschreibung

Die Erfindung betrifft eine Schaltungsanordnung zur Erkennung und Speicherung von Netzfehlern nach den Merkmalen des Oberbegriffs des Patentanspruchs.

Die hohen Stillstandskosten, die beim Ausfall moderner Datenverarbeitungsanlagen entstehen, gebieten die Ursachen eines solchen Ausfalls möglichst rasch und sicher zu erkennen. Besonders schwierig ist dabei die Erkennung sporadischer Fehler, wie sie beispielsweise unzulässig lange Netzeinbrüche darstellen, die zur Abschaltung der Stromversorgung und damit zum Ausfall z. B. eines Rechners führen können.

Eine Schaltungsanordnung nach den Merkmalen des Oberbegriffs des Patentanspruchs ist aus der GB-A-2 023 952 bekannt. Bei dieser bekannten Schaltungsanordnung sind zur Ansteuerung des bistabilen Relais insgesamt drei Transistoren vorgesehen, wobei im fehlerlosen Zustand der Stromversorgung lediglich der erste Transistor dauernd durchgesteuert ist, während die beiden anderen Transistoren, welche die beiden Wicklungen des bistabilen Relais ansteuern, nur für kurze Zeit nach Art einer Impulssteuerung durchgesteuert sind. Bei der bekannten Schaltung sind keine Vorkehrungen getroffen, die beim Hochlaufvorgang ein Ansprechen des Relais vermeiden. Vielmehr muß das Relais nach dem Hochlaufvorgang zunächst zurückgesetzt werden, damit die Schaltung in einen funktionsfähigen Meldezustand gebracht wird. Damit besteht keine Möglichkeit, die Information « kein Netzfehler » zu speichern.

Der vorliegenden Erfindung liegt nun die Aufgabe zugrunde, eine Schaltungsanordnung zur Erkennung und Speicherung von Netzfehlern gemäß den Merkmalen des Oberbegriffs des Patentanspruchs so zu verbessern, daß Netzfehler auch nach Fortfall der Entstehungsursache noch angezeigt bleiben.

Die Lösung dieser Aufgabe ergibt sich erfindungsgemäß durch die kennzeichnenden Merkmale des Patentanspruchs. Durch diese Maßnahmen erhält man eine Schaltung, bei der Netzfehler angezeigt werden können und die nach Abschalten der Stromversorgung bis zum nächsten Wiedereinschalten bzw. trotz der Wiederkehr der Netzeingangsspannung gespeichert bleiben.

Im folgenden wird ein Ausführungsbeispiel der Erfindung anhand der Zeichnung näher erläutert. Dabei zeigen

Figur 1 eine Prinzipschaltung zur Fehlererkennung und Fehlerspeicherung

Figur 2 eine konkrete Ausführungsform der Schaltung nach Fig. 1.

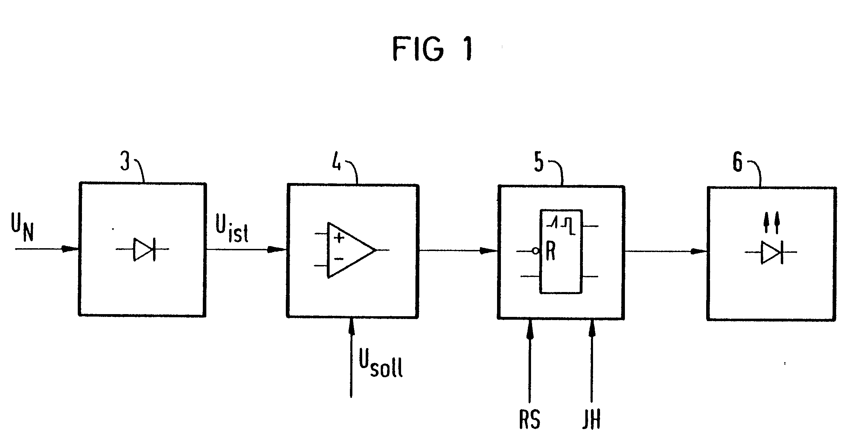

In Fig. 1 ist das Prinzip der Fehlererkennung und Fehlerspeicherung dargestellt. Das Schaltbild zeigt einen Gleichrichter 3, der die Netzeingangsspannung $U_N$ gleichrichtet und den momentanen Istwert $U_{ist}$ der gleichgerichteten Netzeingangsspannung einer Vergleichsschaltung 4 zuführt.

Der Ausgang der Vergleichsspannung 4 ist mit einem Fehlerspeicher 5 verbunden, an dessen Ausgang eine Anzeigeschaltung 6 angeschlossen ist. Zur Netzüberwachung wird die gleichgerichtete Netzeingangsspannung $U_{ist}$ mit einem Sollwert $U_{soll}$ verglichen. Unterschreitet der momentane Istwert $U_{ist}$ den Sollwett $U_{soll}$, so gibt die Netzüberwachung ein Fehlersignal ab. Die Fehlerspeicherung spricht an und bringt den Fehler zur Anzeige. Über ein Resetsignal RS kann die Meldung wieder gelöscht werden. Ein Inhibitsignal IH dient zum Sperren der Speichereinrichtung während des Hochlaufens der gleichgerichteten Netzeingangsspannung. Zudem wird dieses Signal dazu verwendet, die Speichereinrichtung zu sperren, wenn die gesamte Datenverarbeitungsanlage abgeschaltet wird.

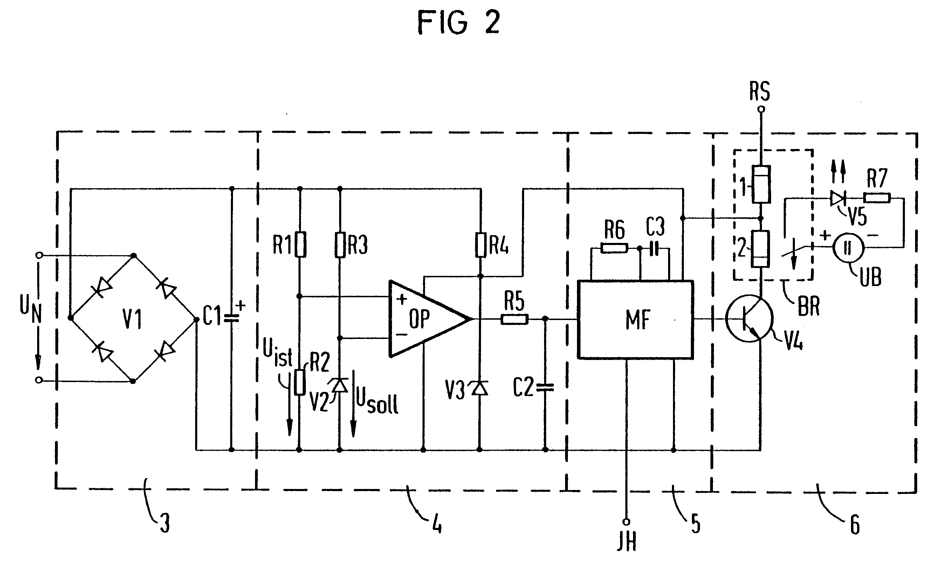

Fig. 2 zeigt die realisierte Schaltung. Über den Gleichrichter V1 und den Siebkondensator C1 wird die Netzeingangsspannung $U_N$ gleichgerichtet und geglättet. Der Sollwert $U_{soll}$ wird über eine Wheatestonsche Brücke, bestehend aus den Ohmschen Widerständen R1, R2, R3 und einer Zenerdiode V2, die als Referenzspannungsquelle für die Sollspannung dient, erzeugt und mit dem momentanen Istwert der gleichgerichteten Netzeingangsspannung verglichen. In der zweiten Brückendiagonale der Wheatestonschen Brücke liegt der Eingang eines Operationsverstärkers, wobei der nichtinvertierende Eingang an den Verbindungspunkt der beiden Ohmschen Widerstände R1, R2 des einen Brückenzweigens der Whitestonschen Brücke und der invertierende Eingang an dem Verbindungspunkt zwischen dem Ohmschen Widerstand R3 und der Zenerdiode V2 des zweiten Brückenzweiges der Wheatestonschen Brücke liegt. Unterschreitet der Istwert den Sollwert, so springt der Ausgang des Operationsverstärkers OP von L auf H-Pegel. Mit diesem Flankenwechsel wird das Monoflop MF gesetzt. Dieses nimmt nun entsprechend der Zeitkonstanten des Kondensators C3 und des Ohmschen Widerstandes R6 H-Pegel an und schaltet für diese Zeit den Transistor V4, dessen Basis mit dem Ausgang des Monoflops verbunden ist, durch. Im Kollektorkreis dieses Transistors liegt das als Speicher dienende bistabile Relais BR, dessen beiden Wicklungen 1, 2 vom Kollektorstrom durchflossen werden, wodurch der Schaltkontakt das Relais BR öffnet. Dadurch erlischt die Lichtemissionsdiode V5, in deren Stromkreis der Relaiskontakt des bistabilen Relais liegt und die Fehlermeldung wird gespeichert. Selbst, wenn jetzt die Netzeingangsspannung weggenommen wird — vorher muß, wie oben beschrieben, am Monoflop MF das Signal IH (Inhibit) angelegt werden, bleibt die Information erhalten. Die Signale RS (Reset) und IH (Inhibit) werden von außen zugeführt, sie können auch aus der Logik einer geeigneten Stromversorgung entnommen werden. Die Versorgungsspannung für die gesamte Schaltung wird direkt der gleichgerichteten Netzeingangsspannung entnommen und über den Ohmschen Widerstand R4 und eine weitere Zenerdiode V3 erzeugt, wobei der Ohmsche Widerstand zwischen dem einen Eckpunkt des Brückengleichrichters V1 und der Kathode der weiteren Z-Diode V3 liegt, während die Zenerdiode V3 zwischen dem Ohmschen Widerstand R4 und dem weiteren Eckpunkt des Brückengleichrichters V1 angeordnet ist. Zwischen Operationsverstärker und Monoflop ist eine Siebschaltung, bestehend aus dem Ohmschen Widerstand R5 und dem Kondensator C2 vorgesehen, die zur Unterdrückung von Störimpulsen führt. Der Ohmsche Widerstand R7 dient als Vorwiderstand für die Lichtemissionsdiode V5, die bei geschlossenem Relais Kontakt über die Gleichspannungsquelle UB versorgt wird. Die beiden Wicklungen des bistabilen Relais sind durch zwei Dioden V6, V7 überbrückt, die eine Schutzwirkung für den Transistor V4 und die Ansteuerelektronik ausüben.

**Patentanspruch**

Schaltungsanordnung zur Erkennung und Speicherung von Netzfehlern, mit einer Vergleichsschaltung, an deren Eingang eine Wheatstone'sche Brücke vorgesehen ist, in deren einem Brückenzweig eine Zenerdiode (V2) als Sollspannungsquelle liegt, an deren einer Diagonale eine gleichgerichtete Netzspannung und an deren anderer Diagonale die Eingänge eines Operationsverstärkers (OP) angeschlossen sind, und mit einem dem Operationsverstärker (OP) nachgeschalteten Speicher, der aus einem von wenigstens einem Transistor (V4) angesteuerten bistabilen Relais (BR) besteht, dadurch gekennzeichnet, daß der Speicher eine monostabile Kippstufe (MF) enthält, die mit einer Sperrspannung (IH) für den Anlaufbetrieb (Inhibitspannung) beaufschlagbar ist und bei einem Netzspannungsfehler einen H-Pegel an den Speicher abgibt, und daß das bistabile Relais (BR) mittels einer Rücksetzspannung (RS) in seinen Ausgangszustand zurückstellbar ist und ausgangsseitig auf eine durch eine Lichtemissionsdiode (V5) gebildete Anzeigeschaltung einwirkt.

**Claim**

A circuit arrangement for the recognition and data storage of defects in power supply systems, comprising a comparison circuit at the input of which a Wheatstone bridge is arranged, where a Zener diode (V2) is connected as a theoretical voltage source in one arm of the bridge, a rectified mains voltage is connected across one diagonal, and the inputs of an operational amplifier (OP) are connected across the other diagonal, and a store which consists of a bistable relay (BR) driven by at least one transistor (V4) is connected to the output of the operational amplifier (OP), characterised in that the store contains a monostable trigger stage (MF) which can be acted upon by an inhibit voltage (IH) for the start operation and which emits an H-level signal to the store in the event of a defect in the mains voltage, that the bistable relay (BR) can be reset to its starting state by means of a reset voltage (RS), and acts upon a display circuit formed by a light-emitting diode (V5) at its output.

**Revendication**

Montage pour détecter et mémoriser des défauts dans un réseau, comportant un circuit comparateur, à l'entrée duquel est prévu un pont de Wheatstone, dans lequel une diode Zener (V2) est branchée en tant que source de tension de consigne dans une branche de ce pont, une tension redressée du réseau est appliquée à une diagonale du pont et les entrées d'un amplificateur opérationnel (OP) sont raccordées à l'autre diagonale du pont, et comportant une mémoire branchée en aval de l'amplificateur opérationnel (OP) et qui est constituée par un relais bistable (BR) commandé par au moins un transistor (V4), caractérisé par le fait que la mémoire comporte un étage à bascule monostable (MF), qui peut être chargé par une tension de blocage (IH) pour le fonctionnement au démarrage (tension d'inhibition) et délivre à la mémoire un niveau H dans le cas d'un défaut de la tension du réseau, et que le relais bistable (B) peut être ramené dans son état initial au moyen d'une impulsion de remise à l'état initial (RS) et agit, du côté sortie, sur un circuit d'affichage formé par une diode photoémissive (V5).

# FIG 1

# FIG 2

RS

U_N

V1

C1

R1    R3

U_ist  R2  V2  U_soll

OP

R4

R5    V3    C2

R6    C3

MF

V4

BR

1

2

V5    R7

UB

JH

3      4      5      6

0 089 048

2